# EUROPEAN PATENT SPECIFICATION

(11) **EP 3 595 425 B1**
(45) Date of publication and mention of the grant of the patent: **26.07.2023**
(21) Application number: 17900099.7
(22) Date of filing: 10.03.2017
(51) Int. Cl.: H05K 13/08, H05K 13/04

(54) **COMPONENT MOUNTING MACHINE**
KOMPONENTENMONTAGEMASCHINE
MACHINE DE MONTAGE DE COMPOSANT

(43) Date of publication of application: 15.01.2020
(73) Proprietor: Fuji Corporation, Chiryu-shi, Aichi 472-8686 (JP)
(72) Inventor: KAWAGUCHI, Koji, Chiryu Aichi (JP); SUGIHARA, Kohei, Chiryu Aichi (JP); IWATA, Naoya, Chiryu Aichi (JP)
(74) Representative: Grünecker Patent- und Rechtsanwälte PartG mbB
(86) International application number: PCT/JP2017/009653
(87) International publication number: WO 2018/163394

(56) References cited:
- EP-A1- 3 061 331
- EP-B1- 3 061 331
- WO-A1-2014/155535
- JP-A- H05 191 097
- JP-A- 2006 073 745

## Description

### Technical Field

The present specification discloses a component mounting machine.

### Background Art

Conventionally, as a component mounting machine, there has been known a component mounting machine for mounting a component on a board by picking up the component with a nozzle and then moving the nozzle to a predetermined position on the board to release the picked-up component. Patent Literature 1 suggests a component mounting machine in which the speed with which a component collides with the top surface of a board is controlled to suppress the impact force to be equal to or less than a regulated value. The component mounting machine of Patent Literature 1 measures the actual impact force that is generated with a pressure sensor, analyzes the correlation between the collision speed and the collision force from the actual measured data, and determines the subsequent collision speed based on the correlation.
Further related background art is disclosed in Patent Literature 2.

### Patent Literature

Patent Literature 1: JP-A-2001-57498
Patent Literature 2: EP 3 061 331 A1

### Summary of the Invention

### Technical Problem

However, in the above-described component mounting machine, although the correlation between the collision speed and the collision force is analyzed, hardness characteristics of the nozzle upon coming into contact with the board are not considered. Even at the same collision speed, when the board, the component, or the nozzle are hard, the peak load is large, and when the board, the component, or the nozzle are soft, the peak load is small. In the above-described component mounting machine, since such hardness characteristics are not considered, the determined collision speed is not always at an appropriate speed.

The present disclosure has been made in order to solve the above-described problem, and a main object of the present disclosure is to easily obtain hardness characteristics when a component holding tool comes into contact with a board.

### Solution to Problem

In order to solve the above problem, the present invention provides component mounting machines as defined in claims 1 and 2.

In the component mounting machines, the hardness characteristics when the component holding tool comes into contact with the board are obtained based on the load information detected by the load detector when the head is controlled such that the component holding tool comes into contact with the board. As a result, the hardness characteristics when the component holding tool comes into contact with the board can be easily obtained.

In addition, "the component holding tool comes into contact with the board" includes not only a case where the component holding tool that does not hold a component comes into direct contact with the board, but also a case where the component holding tool that holds the component comes into indirect contact with the board via the component.

### Brief Description of Drawings

[Fig. 1] Fig. 1 is a perspective view of component mounting machine 10.
[Fig. 2] Fig. 2 is an explanatory diagram of mounting head 18.
[Fig. 3] Fig. 3 is a sectional view of nozzle 42.
[Fig. 4] Fig. 4 is an external view of nozzle 42.
[Fig. 5] Fig. 5 illustrates electrical connections of controller 78.
[Fig. 6] Fig. 6 is a flowchart of a component mounting processing routine.
[Fig. 7] Fig. 7 is a flowchart of a component test hitting routine.
[Fig. 8] Fig. 8 illustrates before and after component P comes into contact with board S.
[Fig. 9] Fig. 9 is a graph illustrating an example of reaction force time-dependent data.
[Fig. 10] Fig. 10 is a graph illustrating a correspondence between reaction force time-dependent data and hardness characteristics at low speed VL.
[Fig. 11] Fig. 11 is a graph illustrating a correspondence between the reaction force time-dependent data and the hardness characteristics at medium speed VM.
[Fig. 12] Fig. 12 is a graph illustrating a correspondence between the reaction force time-dependent data and the hardness characteristics at high speed VH.
[Fig. 13] Fig. 13 is a table illustrating the correspondence of the hardness characteristics, the reaction force increase rate, and the peak reaction force at low speed VL, medium speed VM, and high speed VH.

### Description of Embodiments

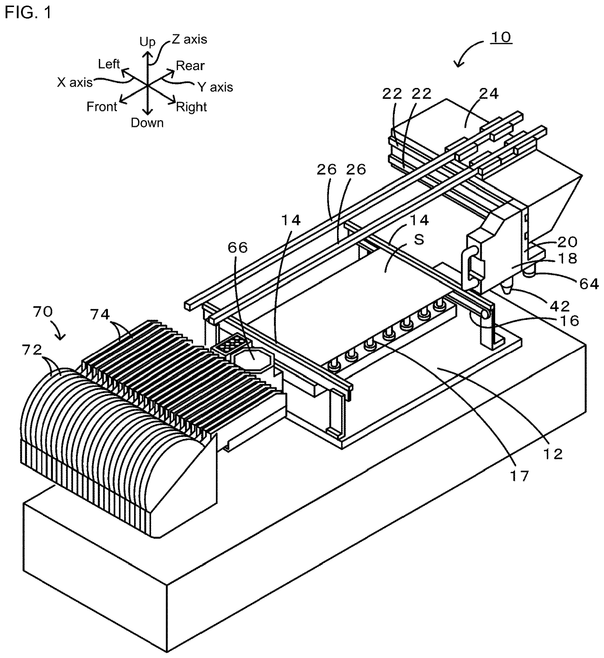

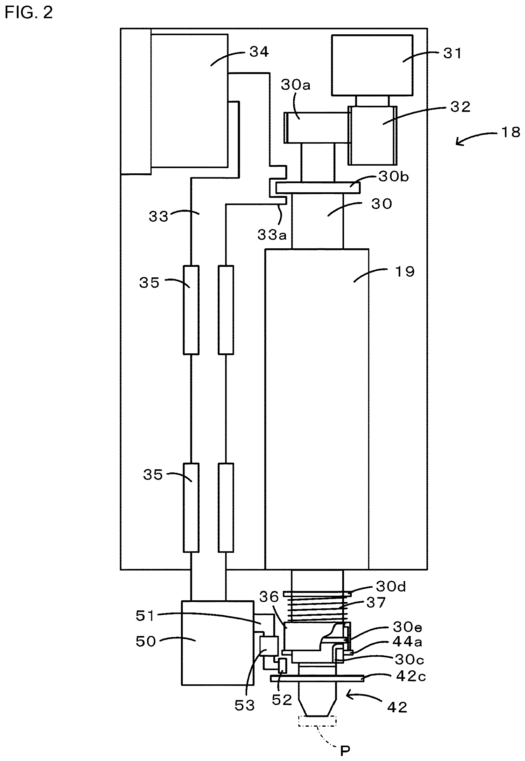

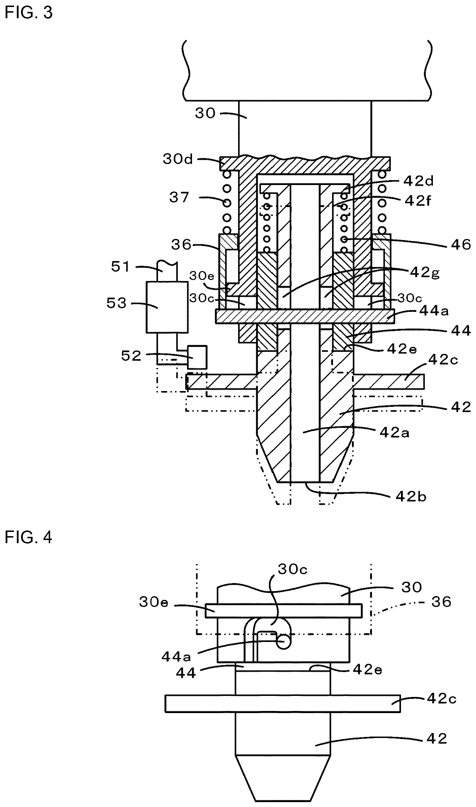

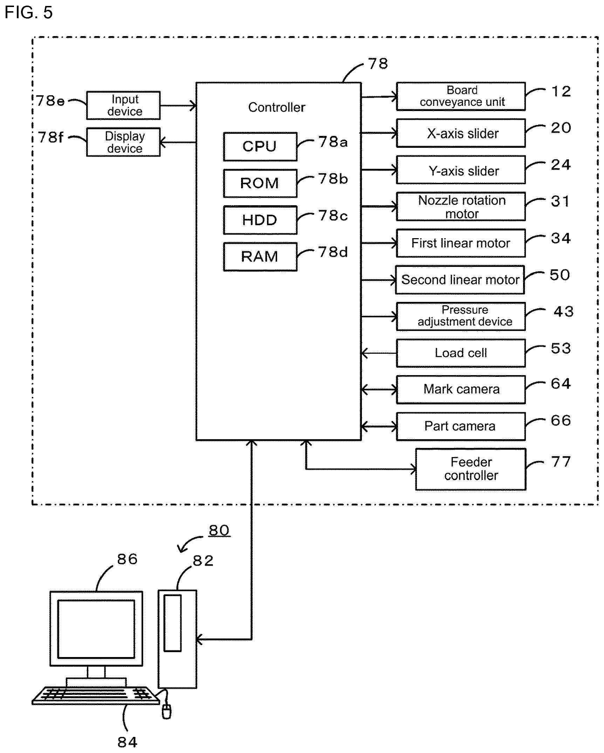

Preferred embodiments of the component mounting machine of the present invention will be described below with reference to the drawings. Fig. 1 is a perspective view of component mounting machine 10, Fig. 2 is an explanatory diagram of mounting head 18, Fig. 3 is a sectional view of nozzle 42, Fig. 4 is an external view of nozzle 42, and Fig. 5 illustrates electrical connections of controller 78. In addition, in the present embodiment, the left-right direction (X-axis), the front-rear direction (Y-axis), and the up-down direction (Z-axis) are as illustrated in Fig. 1.

As illustrated in Fig. 1, component mounting machine 10 includes board conveyance unit 12, mounting head 18, nozzle 42, mark camera 64, part camera 66, component supply unit 70, and controller 78 (refer to Fig. 5) that executes various controls.

Board conveyance unit 12 conveys board S from left to right by conveyor belts 16 and 16 (only one of which is illustrated in Fig. 1) attached to a pair of front and rear support plates 14 and 14, respectively. In addition, board conveyance unit 12 fixes board S by uplifting board S from below with support pins 17 disposed below board S, and releases the fixation of board S by lowering support pins 17.

Mounting head 18 is movable in an XY-plane. Specifically, mounting head 18 moves in the left-right direction as X-axis slider 20 moves in the left-right direction along guide rails 22 and 22, and moves in the front-rear direction as Y-axis slider 24 moves in the front-rear direction along guide rails 26 and 26. As illustrated in Fig. 2, mounting head 18 has support cylinder 19 that supports nozzle holder 30 so as to be capable of rotating axially and moving up and down. Nozzle holder 30 is a member that extends in the up-down direction, has rotation transmission gear 30a and flange 30b at an upper portion thereof, and holds nozzle 42 at a lower portion thereof. Rotation transmission gear 30a meshes with driving gear 32 of nozzle rotation motor 31. Therefore, when nozzle rotation motor 31 rotates, nozzle holder 30 axially rotates accordingly. Flange 30b is sandwiched between upper and lower pieces of first engaging section 33a provided in first arm 33 that extends in the up-down direction. First arm 33 is connected to a movable element of first linear motor 34. A stator of first linear motor 34 is fixed to mounting head 18. Therefore, when the movable element of first linear motor 34 moves up and down, first arm 33 moves up and down along guide member 35 that guides the movement in the up-down direction accordingly, and not only flange 30b sandwiched by first engaging section 33a but also nozzle holder 30 moves up and down together with the up-down movement. A pair of inverted J-shaped guide grooves 30c (refer to Fig. 4) are provided on a lower end side face of nozzle holder 30 at positions facing each other. As illustrated in Figs. 2 and 3, an upper annular protrusion 30d and a lower annular protrusion 30e are provided on a side face of nozzle holder 30 with a space therebetween. Nozzle holder 30 is covered with lock sleeve 36. Since the diameter of an upper opening of lock sleeve 36 is smaller than the diameter of upper annular protrusion 30d or lower annular protrusion 30e of nozzle holder 30, lock sleeve 36 can move up and down without falling off from nozzle holder 30. Lock spring 37 is disposed between the upper end face of lock sleeve 36 and upper annular protrusion 30d of nozzle holder 30.

Nozzle 42 picks up component P at a nozzle tip or separates component P picked up at the nozzle tip by using pressure. As illustrated in Fig. 3, nozzle 42 is elastically supported by an upper end face of nozzle sleeve 44 which is a nozzle fixture via nozzle spring 46. Nozzle 42 has ventilation passage 42a that extends in the up-down direction inside. Ventilation passage 42a can be supplied with a negative pressure or a positive pressure. Nozzle 42 has flange 42c that protrudes horizontally from a position slightly above suction port 42b for picking up component P, spring receiving section 42d that protrudes horizontally from the upper end, and step surface 42e provided between the upper end and flange 42c. A part of nozzle 42 from step surface 42e to spring receiving section 42d is shaft section 42f having a small diameter. A pair of long holes 42g that extends in the up-down direction are provided on the side face of shaft section 42f so as to face each other. Nozzle sleeve 44 is mounted on nozzle 42 so as to be movable up and down relative to shaft section 42f of nozzle 42. Nozzle sleeve 44 is integrated with pin 44a that penetrates nozzle sleeve 44 in a diametrical direction. Pin 44a is inserted through the pair of long holes 42g of nozzle 42. Therefore, nozzle 42 is slidable in the direction in which long hole 42g extends, that is, in the up-down direction, with respect to pin 44a. Nozzle spring 46 is disposed between the upper end face of nozzle sleeve 44 and spring receiving section 42d of nozzle 42.

Nozzle sleeve 44 is detachably fixed to guide groove 30c of nozzle holder 30 in a state where nozzle 42 is elastically supported. Pin 44a provided on nozzle sleeve 44 is fixed in a state of being sandwiched between a tail end of guide groove 30c and the lower end of lock sleeve 36 biased downward by lock spring 37. When fixing nozzle sleeve 44 that elastically supports nozzle 42 to nozzle holder 30, first, pin 44a of nozzle sleeve 44 is moved upward along guide groove 30c (refer to Fig. 4) of nozzle holder 30. Then, pin 44a abuts against the lower end of lock sleeve 36. Thereafter, while lock sleeve 36 is uplifted by pin 44a against the elastic force of lock spring 37, nozzle 42 is rotated together with nozzle sleeve 44 with respect to lock sleeve 36 such that pin 44a enters along guide groove 30c. Then, pin 44a passes through the horizontal part of guide groove 30c and finally moves downward to reach the tail end of guide groove 30c. At this time, pin 44a is in a state of being pressed against the tail end of guide groove 30c by lock sleeve 36 biased downward by lock spring 37. As a result, nozzle sleeve 44 is locked to nozzle holder 30 via pin 44a. In addition, when nozzle sleeve 44 that elastically supports nozzle 42 is detached from nozzle holder 30, the procedure opposite to the procedure of fixing may be performed.

Returning to Fig. 2, a stator of second linear motor 50 is fixed to the lower end of first arm 33. Second arm 51 is connected to a movable element of second linear motor 50. Second arm 51 includes second engaging section 52 formed of a cam follower at the tip end of the arm, and includes load cell 53 for detecting a load in the middle of the arm. Second engaging section 52 is disposed at a position facing the upper face of flange 42c of nozzle 42. When the movable element of second linear motor 50 moves downward, second engaging section 52 of second arm 51 pushes flange 42c downward against the elastic force of nozzle spring 46 accordingly, and thus nozzle 42 moves downward with respect to pin 44a of nozzle sleeve 44, that is, nozzle holder 30 (refer to the two-dot chain line in Fig. 3). Thereafter, when the movable element of second linear motor 50 moves upward, the force for pressing flange 42c downward is weakened, and thus nozzle 42 moves upward with respect to pin 44a, that is, nozzle holder 30, by the elastic force of nozzle spring 46.

Returning to Fig. 1, mark camera 64 is installed at the lower end of X-axis slider 20 such that the imaging direction faces board S, and is movable along with the movement of mounting head 18. Mark camera 64 images a reference mark for positioning the board (not illustrated) provided on board S and outputs the obtained image to controller 78.

Part camera 66 is installed between component supply unit 70 and board conveyance unit 12 such that the imaging direction is upward at substantially the center of the length in the left-right direction. Part camera 66 images a component picked up by nozzle 42 that passes thereabove, and outputs the image obtained by the imaging to controller 78.

Component supply unit 70 includes reel 72 and feeder 74. Reel 72 is wound with a tape formed such that the recessed sections for accommodating the components are aligned along a longitudinal direction. Feeder 74 feeds the components of the tape wound on reel 72 to a predetermined component supply position. The tape wound on reel 72 has a film that covers the component, but the film is peeled off when the film reaches the component supply position. Therefore, the component disposed at the component supply position is brought into a state of being capable of being picked up by nozzle 42.

As illustrated in Fig. 5, controller 78 is configured as a microprocessor centered on CPU 78a and includes ROM 78b for storing a processing program, HDD 78c for storing various types of data, RAM 78d used as a work region, and the like. In addition, input device 78e, such as a mouse or a keyboard, and display device 78f, such as a liquid crystal display, are connected to controller 78. Controller 78 is connected to feeder controller 77 built in feeder 74 or management computer 80 so as to be capable of performing bidirectional communication. In addition, controller 78 is connected to output control signals to board conveyance unit 12, X-axis slider 20, Y-axis slider 24, nozzle rotation motor 31, first and second linear motors 34 and 50, pressure adjustment device 43 of nozzle 42, mark camera 64, and part camera 66. Further, controller 78 is connected to receive a detection signal from load cell 53 and an image signal from mark camera 64 or part camera 66. For example, controller 78 processes the image of board S captured by mark camera 64 to recognize the position of the reference mark, thereby recognizing the position (coordinates) of board S. In addition, controller 78 determines whether the component is picked up with nozzle 42 based on the image captured by part camera 66, and determines the shape, size, suction position, and the like of the component.

As illustrated in Fig. 5, management computer 80 includes personal computer main body 82, input device 84, and display 86, can input signals from input device 84 operated by an operator, and can output various images to display 86. Production job data is stored in the memory of personal computer main body 82. In the production job data, which components P are mounted on board S in which order in each component mounting machine 10, how many boards S mounted in this manner are produced, and the like, are defined.

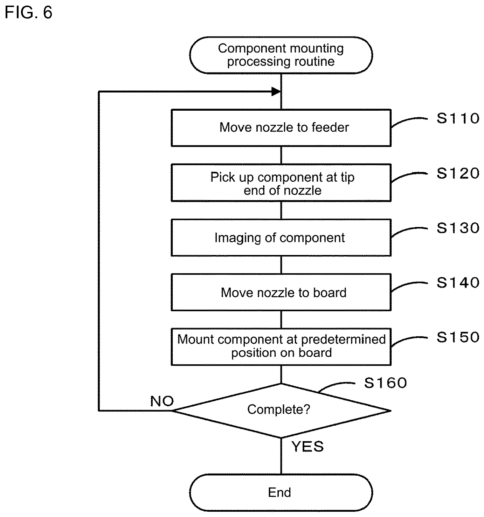

Next, an operation in which controller 78 of component mounting machine 10 mounts component P on board S based on the production job will be described. Fig. 6 is a flowchart of a component mounting processing routine. Programs of the component mounting processing routine are stored in HDD 78c of the controller 78.

When the routine is initiated, CPU 78a of controller 78 first moves nozzle 42 to feeder 74 (step S110). Specifically, by controlling X-axis and Y-axis sliders 20 and 24, CPU 78a moves nozzle 42 to a component supply position of feeder 74 that supplies predetermined component P in component supply unit 70.

Subsequently, CPU 78a picks up component P with the tip end of nozzle 42 (step S120). Specifically, CPU 78a moves nozzle holder 30 downward by lowering the movable element of first linear motor 34. In parallel with this, CPU 78a moves nozzle 42 to the lowermost end with respect to nozzle holder 30 by lowering the movable element of second linear motor 50 before the tip end of nozzle 42 abuts against component P. Thereafter, CPU 78a controls the movable element of second linear motor 50 such that the reaction force is equal to a set pushing force when it is determined that the tip end of nozzle 42 comes into contact with component P based on the detection signal from load cell 53. Accordingly, it is possible to prevent component P from being damaged by nozzle 42. Further, CPU 78a controls pressure adjustment device 43 such that the negative pressure is supplied to suction port 42b at the time when the tip end of nozzle 42 comes into contact with component P. Accordingly, component P is picked up with the tip end of nozzle 42.

Next, CPU 78a images component P by part camera 66 (step S130). Specifically, CPU 78a controls second linear motor 50 such that second engaging section 52 of second arm 51 is separated above flange 42c and controls first linear motor 34 such that component P has a predetermined height. In parallel with this, CPU 78a controls X-axis and Y-axis sliders 20 and 24 such that the center position of nozzle 42 matches a predetermined reference point of the imaging region of part camera 66 and images component P by part camera 66 at the time when the center position of nozzle 42 matches the reference point. CPU 78a grasps the position of component P with respect to the reference point by analyzing the captured image.

Subsequently, CPU 78a moves nozzle 42 onto board S (step S140). Specifically, by controlling X-axis and Y-axis sliders 20 and 24, CPU 78a moves nozzle 42 to a position above a predetermined component mounting position on board S where component P is mounted.

Subsequently, CPU 78a mounts component P at a predetermined component mounting position on board S (step S150). Specifically, CPU 78a controls nozzle rotation motor 31 such that the orientation of component P becomes a predetermined orientation based on the captured image. In addition, CPU 78a moves nozzle holder 30 downward by lowering the movable element of first linear motor 34. Then, CPU 78a stops the movable element of first linear motor 34 and lowers the movable element of second linear motor 50 at a constant speed before component P picked up with the tip end of nozzle 42 abuts against board S. Thereafter, when it is determined that component P comes into contact with board S based on the detection signal from load cell 53, CPU 78a controls the movable element of second linear motor 50 such that the reaction force becomes equal to the set pushing force. Accordingly, it is possible to prevent component P from being damaged by the collision with board S. Further, CPU 78a controls pressure adjustment device 43 such that the positive pressure is supplied to the tip end of nozzle 42 at the time when component P abuts against board S. Accordingly, component P is mounted at a predetermined component mounting position on board S.

Subsequently, CPU 78a determines whether the mounting of the component to be mounted on board S has been completed (step S160), and when the mounting is not completed, CPU 78a executes the processes of S110 and subsequent steps with respect to the next component P, and when the mounting is completed, CPU 78a ends the present routine.

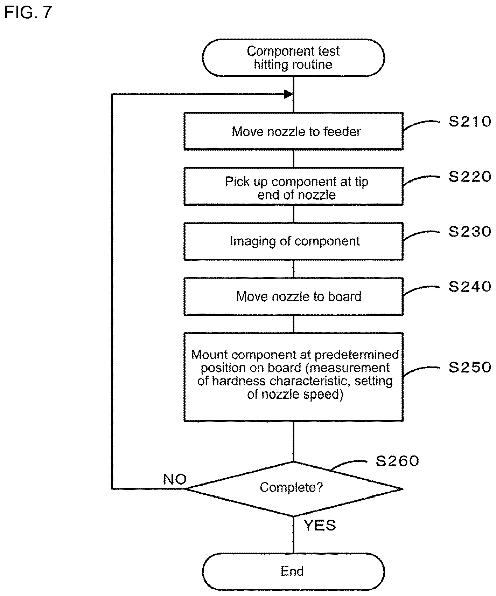

Controller 78 of component mounting machine 10 executes a component test hitting routine prior to the component mounting processing routine. Fig. 7 is a flowchart of the component test hitting routine. Programs of the component test hitting routine are stored in HDD 78c of controller 78. Since steps S210 to S240 of the component test hitting routine is the same as steps S110 to S140 of the component mounting processing routine, only step S250 and the subsequent steps will be described below. In addition, the component test hitting routine is usually performed with respect to one board S.

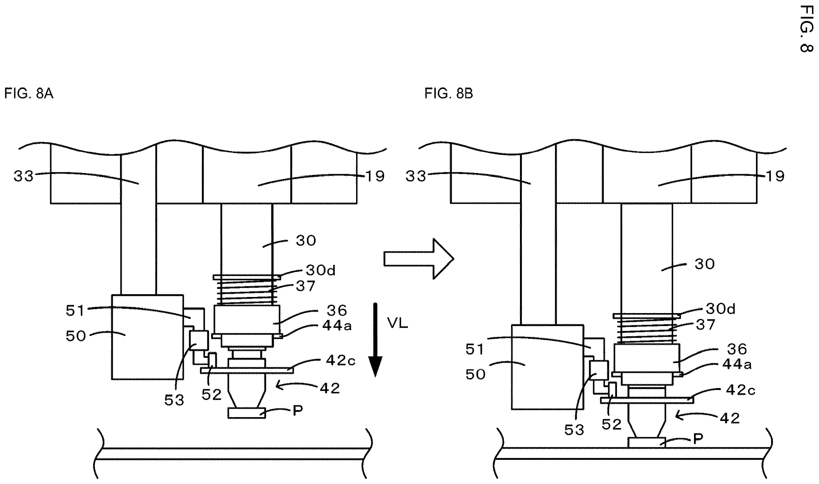

In step S250, CPU 78a of controller 78 causes component P to be mounted to a predetermined component mounting position on board S. Specifically, CPU 78a controls nozzle rotation motor 31 such that the orientation of component P becomes a predetermined orientation based on the captured image. In addition, CPU 78a moves nozzle holder 30 downward by lowering the movable element of first linear motor 34. In parallel with this, CPU 78a moves nozzle 42 to the lowermost end with respect to nozzle holder 30 by lowering the movable element of second linear motor 50 before component P, picked up by the tip end of nozzle 42, abuts against board S (refer to Fig. 8A). At this time, the nozzle lowering speed (speed of approaching board S) of nozzle 42 is set to predetermined low speed VL. Thereafter, when it is determined that component P is in contact with board S based on the detection signal from load cell 53, CPU 78a controls the movable element of second linear motor 50 such that the reaction force is equal to the set pushing force (board impact softening processing, refer to Fig. 8B). Although the reaction force (the load applied to board S) increases rapidly due to the collision of component P with board S, in the present embodiment, the reaction force can be suppressed because a highfrequency control system in which a cycle of executing the board impact softening processing is short is employed.

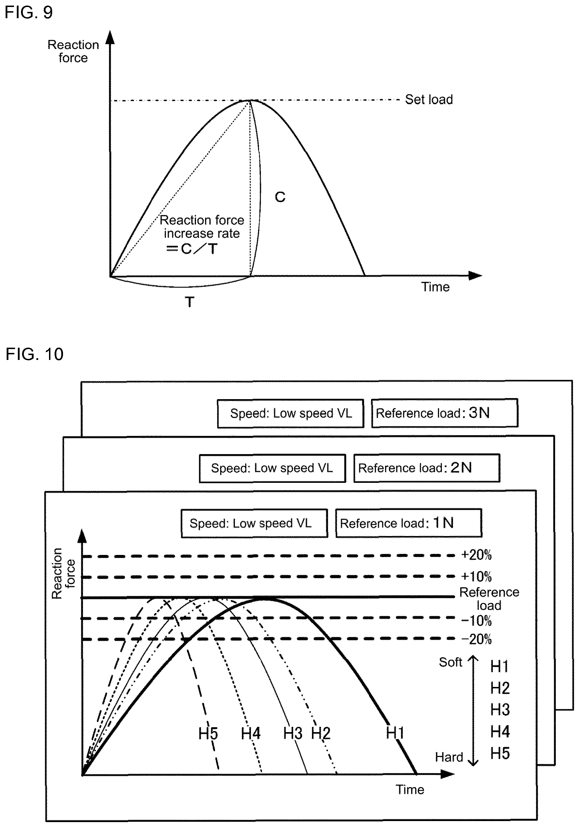

In step S250, CPU 78a further controls the peak reaction force after component P collides with board S such that the peak reaction force becomes a preset load (set load). In addition, CPU 78a detects the reaction force after the collision over time with load cell 53, calculates the reaction force increase rate (load increase rate) based on the reaction force time-dependent data (load information, load time-dependent data) that represents the time-dependent change of the obtained reaction force, and obtains the hardness characteristics measured when component P comes into contact with board S based on the reaction force increase rate. An example of the reaction force time-dependent data is illustrated in Fig. 9. The reaction force increase rate is expressed as C/T when T is the time from the time when component P collides with board S to the time when the reaction force reaches a peak, and C is a value at the peak time of the reaction force. In the present embodiment, the hardness characteristics are determined by three factors, namely, hardness of board S, hardness of nozzle 42, and hardness of component P held by nozzle 42.

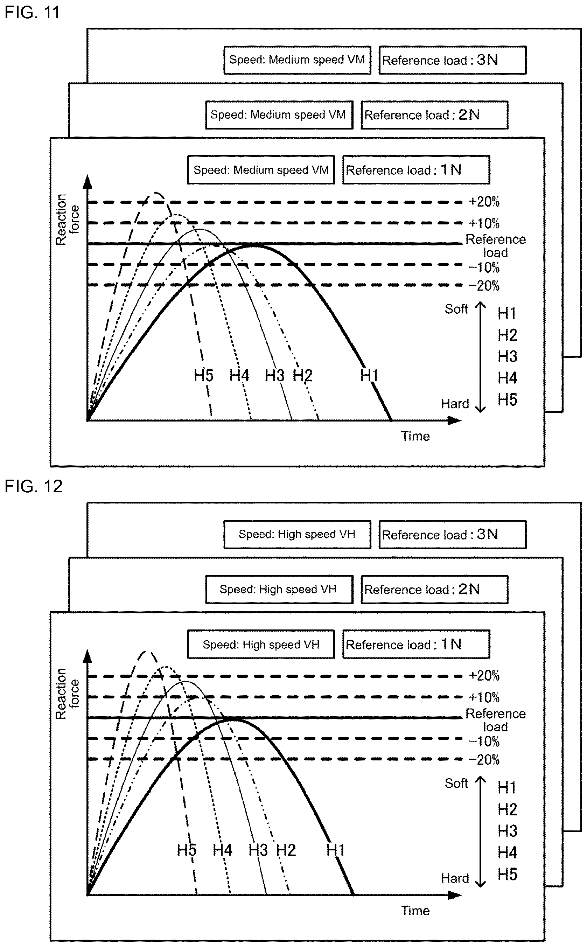

In HDD 78c, a correspondence between the reaction force time-dependent data and the hardness characteristics are stored for each reference load (reference value of the load applied to board S). Here, the reference loads are 1N, 2N, and 3N. The hardness characteristics are divided into multiple stages. Here, the hardness characteristics are divided into five stages of H1 to H5, and are determined so as to become harder from H1 to H5. Such a correspondence is stored for each of the preset nozzle lowering speeds (here, low speed VL, medium speed VM, and high speed VH). Figs. 10 to 12 are graphs illustrating the correspondence between the reaction force time-dependent data and the hardness characteristics for each nozzle lowering speed. Fig. 10 is a graph illustrating the correspondence between the reaction force time-dependent data and the hardness characteristics measured when the nozzle lowering speed is low speed VL. The correspondence at low speed VL is stored for each reference load. Low speed VL is set to a speed that can be controlled by the board impact softening processing such that the peak reaction force becomes the reference load, regardless of the stage of the hardness characteristics. Fig. 11 is a graph illustrating the correspondence between the reaction force time-dependent data and the hardness characteristics measured when the nozzle lowering speed is medium speed VM. The correspondence of medium speed VM is also stored for each reference load. At medium speed VM, there is a case where the peak reaction force exceeds the reference load depending on the stage of the hardness characteristics, even when the board impact softening processing is performed. Fig. 12 is a graph illustrating the correspondence between the reaction force time-dependent data and the hardness characteristics measured when the nozzle lowering speed is high VH. The correspondence of high speed VH is also stored for each reference load. At high speed VH, the peak reaction force exceeds the reference load even when the board impact softening processing is executed with more hardness characteristics than at medium speed VM.

In step S250, in a case where CPU 78a obtains the hardness characteristics based on the reaction force increase rate, CPU 78a selects a set value that matches or is replaceable with the current set load (set value of the load applied to board S) from among the correspondences of low speeds VL stored in HDD 78c. The set load is set by the operator. For example, in a case where the set load is 1N, the correspondence of the set load 1N with low speed VL is selected, the reaction force increase rate of each of hardness characteristics H1 to H5 is obtained from the correspondence, and the obtained reaction force increase rate and the reaction force increase rate calculated at this time are compared with each other to determine the hardness characteristics. For example, when the reaction force increase rate calculated at this time matches the reaction force increase rate of hardness characteristics H3, the hardness characteristics are determined to be H3. In a case where the reaction force increase rate calculated at this time is between the reaction force increase rate of the hardness characteristics H2 and the reaction force increase rate of the hardness characteristics H3, the hardness characteristics may be determined to be H2, but here, the hardness characteristics are determined to be H3. This is because it is preferable to determine hardness characteristics to be rather high in order to avoid damage or the like of component P.

CPU 78a sets the nozzle lowering speed based on the determined hardness characteristics and the set load. Here, a case where the determined hardness characteristics are H3 and the set load is 1N will be described as an example. In addition, it is also assumed that the operator sets a permissible range for the set load. When taking a look at the correspondence between medium speed VM and high speed VH in a case where the hardness characteristics are H3 and the set load is 1N (refer to Figs. 11 and 12), provided the permissible range is 20%, since the peak reaction force is within the permissible range even at high speed VH, the nozzle lowering speed is set to high speed VH. On the other hand, when the permissible range is 10%, the nozzle lowering speed is set to medium speed VM because the permissible range is out of the permissible range at high speed VH and the permissible range is within the permissible range at medium speed VM.

After step S250, CPU 78a determines whether the mounting of the component to be mounted on board S is completed (step S260), and when the mounting is not completed, the processing of step S210 and subsequent steps are executed with respect to next component P, and when the mounting is completed, CPU 78a ends the present routine. After the component test hitting routine is ended, a state where the nozzle lowering speed when mounting component P is set for each predetermined component mounting position of board S. Therefore, in the component mounting processing routine executed after the component test hitting routine, component P can be mounted at the set nozzle lowering speed for each component mounting position.

Here, the correspondence between the constituent elements of component mounting machine 10 of the present embodiment and the constituent elements of the component mounting machine of the present disclosure will be described. Component supply unit 70 corresponds to a component supply device, board conveyance unit 12 corresponds to a board holding device, mounting head 18 corresponds to a head, load cell 53 corresponds to a load detector, X-axis slider 20 and Y-axis slider 24 correspond to a head moving device, and controller 78 corresponds to a control device. In addition, nozzle 42 corresponds to the component holding tool, and HDD 78c corresponds to the storage device. Further, nozzle sleeve 44, nozzle spring 46, second linear motor 50, second arm 51, and second engaging section 52 correspond to an impact softening mechanism.

With component mounting machine 10 described in detail above, the hardness characteristics measured when nozzle 42 comes into contact with board S via component P can be easily obtained based on the reaction force time-dependent data detected by load cell 53 when mounting head 18 is controlled such that nozzle 42 comes into contact with board S via component P.

In addition, generally, the harder the hardness characteristics are, the higher the reaction force increase rate becomes. CPU 78a calculates the reaction force increase rate based on the reaction force time-dependent data and obtains the hardness characteristics based on the reaction force increase rate. Specifically, the hardness characteristics that correspond to the calculated reaction force increase rate are obtained by using the correspondence between the reaction force time-dependent data stored in HDD 78c and the hardness characteristics. Therefore, the hardness characteristics can be obtained with high precision.

Furthermore, the relationship between the reaction force increase rate and the hardness characteristics changes depending on the load applied to board S. CPU 78a selects a reference load that matches or is replaceable with the set load from among multiple reference loads and obtains the hardness characteristics by using the correspondence of the selected reference loads. Therefore, the hardness characteristics can be obtained with high precision.

Furthermore, since the nozzle lowering speed is set based on the hardness characteristics and the preset load, it is possible to set the nozzle lowering speed to a nozzle lowering speed that corresponds to the set nozzle lowering speed, for example, to a nozzle lowering speed at which component P is not damaged. In addition, since the nozzle lowering speed is set to a speed close to the upper limit of the permissible range of the set load, the time required for component mounting can be shortened.

Further, since CPU 78a sets the nozzle lowering speed for each component mounting position on board S, the nozzle lowering speed can be set more appropriately. For example, even in a case of the same board S, at the component mounting position directly above support pin 17 and the component mounting position between support pins 17, the hardness characteristics differ due to different deflection and the like, but even in such a case, the nozzle lowering speed can be appropriately set.

Further, CPU 78a obtains the hardness characteristics by using the reaction force time-dependent data when nozzle 42 comes into contact with board S via component P at predetermined low speed VL and sets the nozzle lowering speed at which nozzle 42 approaches board S to low speed VL or medium speed VM or high speed VH higher than low speed VL based on the obtained hardness characteristics. For example, when the hardness characteristics are soft, even when setting the nozzle lowering speed to high speed VH, trouble is not caused, but when the hardness characteristics are hard, there is a possibility that component P will be damaged if the nozzle lowering speed is not set to low speed VL. With this in consideration, the nozzle lowering speed can be set.

Furthermore, CPU 78a controls second engaging section 52 of second arm 51 so as to cancel the reaction force generated when nozzles 42 comes into contact with board S via component P. Therefore, even when the nozzle lowering speed of nozzle 42 is high to a certain degree, it is possible to prevent component P held by nozzle 42 from being broken by the impact when component P comes into contact with board S.

In addition, the present invention is not limited to any of the above-described embodiments, and it is needless to say that the present invention can be achieved in various modes as long as the embodiment falls under the technical scope of the appended claims.

For example, in the above-described embodiment, an example has been described in which nozzle 42 that holds component P comes into indirect contact with board S via component P in a case where nozzle 42 comes into contact with board S, but, the present invention is not particularly limited thereto, and for example, nozzle 42 that does not hold component P may come into direct contact with board S. Even in this case, the same effect as that of the above-described embodiment can be obtained. For example, in a case where the change in hardness characteristics due to the presence or absence of component P is small, the component test hitting routine may be performed without the component.

In the above-described embodiment, a case of determining the hardness characteristics or the nozzle lowering speed when the set load is 1N has been described, but in a case where the correspondence is not stored in HDD 78c similar to a case where the set load is 1.1N, the hardness characteristics or the nozzle lowering speed may be determined as follows. In other words, a reference value that is replaceable with the set load 1.1N may be selected from among the multiple reference loads 1N, 2N, and 3N, and the hardness characteristics or the nozzle lowering speed may be obtained by using the correspondence of the selected reference load. For example, the hardness characteristics or the nozzle lowering speed may be determined by using the correspondence of the reference load 1N that is the closest to the set load 1.1N. Otherwise, in order to safely avoid damage or the like of component P, the nozzle lowering speed may be determined by using the correspondence of the reference load 2N that is the closest to the set load 1.1N at a value greater than the set load 1.1N.

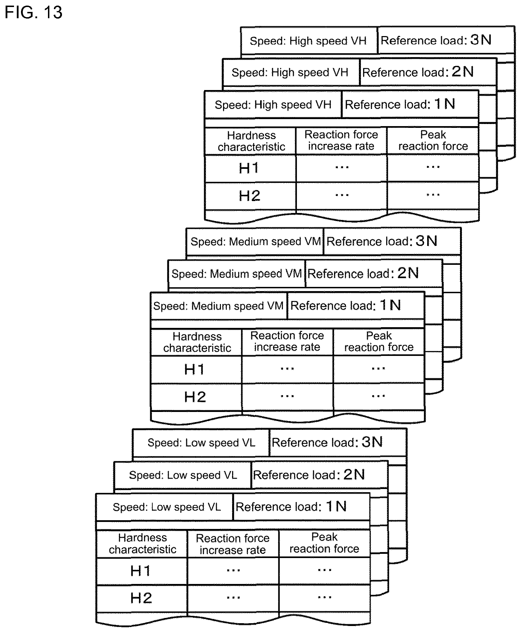

In the above-described embodiment, the hardness characteristics are obtained from the calculated reaction force increase rate by using the correspondence between the reaction force time-dependent data (graph of the reaction force with respect to time) and the hardness characteristics, but as illustrated in Fig. 13, the hardness characteristics may be obtained by using a table in which the correspondence of the hardness characteristics, the reaction force increase rate, and the peak reaction force is determined in advance. Even in this case, the same effect as that of the above-described embodiment can be obtained. In addition, the peak reaction force is used when determining the nozzle lowering speed, but the peak reaction force is not essential when determining the hardness characteristics.

In the above-described embodiment, nozzle 42 is given as an example of the component holding tool, but the present invention is not particularly limited thereto, and for example, a chuck that grasps and holds component P may be used. Even in this case, the same effect as that of the above-described embodiment can be obtained.

In the above-described embodiment, the hardness characteristics are a parameter that depends not only on the hardness of board S but also on the hardness of component P or the hardness of nozzle 42, but in a case where the hardness of component P or the hardness of nozzle 42 is known in advance, the obtained hardness characteristics may be corrected based on the hardness of component P or the hardness of nozzle 42 to calculate the hardness of board S, and the hardness of board S may be used.

In the above-described embodiment, an example has been described in which only one nozzle holder 30 is provided as mounting head 18 for detachably holding nozzle 42, but multiple nozzle holders 30 may be provided at equal angular intervals around the rotor having a vertical axis as the rotation center. For a specific configuration, refer to Fig. 6 of Patent Literature 1 (WO2014/080472). Even in such a configuration, the same effect as that of the above-described embodiment can be obtained.

In the above-described embodiment, the hardness characteristics that correspond to the reaction force increase rate are obtained, but instead of this, the hardness characteristics that correspond to the time-dependent data may be obtained using the correspondence between the time-dependent data and the hardness characteristics. In this manner, the hardness characteristics can be obtained from the similarity between the time-dependent data stored in advance and the actual detected time-dependent data without calculating an index, such as the reaction force increase rate.

In the above-described embodiment, C/T is used as the load increase rate, but instead of C/T, the time until reaching a predetermined load before the peak of the time-dependent data may be used, or a load value (reaction force value) at the time when a predetermined time elapses after component P comes into contact with board S may be used, or the time until reaching the peak may be used.

In the above-described embodiment, load cell 53 is given as an example of the load detector, but instead of load cell 53, controller 78 (or a current monitoring section) may detect the load by monitoring the load current of second linear motor 50.

In the above-described embodiment, after determining the nozzle lowering speed, component mounting machine 10 may transmit the nozzle lowering speed to management computer 80. Management computer 80 may simulate the production time based on the received nozzle lowering speed and notify the operator of the production time. In this manner, the user can be informed about the production time and review the production plan.

The component mounting machine of the present invention may be configured as follows.

In the component mounting machine of the present invention, the load information is the time-dependent data that represents the time-dependent change of the load. The time-dependent data is used to determine the hardness characteristics measured when the component holding tool comes into contact with the board.

In the component mounting machine of the present disclosure, the control device may calculate the load increase rate per time measured when the load rises based on the load information and may calculate the hardness characteristics based on the load increase rate. Generally, the harder the hardness of the contact parts is, the higher the load increase rate becomes. Therefore, the hardness characteristics can be obtained with high precision by using the load increase rate. In this case, the component mounting machine of the present disclosure includes a storage device configured to store a correspondence between the load increase rate and the hardness characteristics, and the control device obtains the hardness characteristics that correspond to the load increase rate using the correspondence stored in the storage device.

In the component mounting machine of the present invention, the load information may be alternatively time-dependent data that represents a time-dependent change of the load, the machine may further include a storage device configured to store a correspondence between the time-dependent data and the hardness characteristics, and the control device may obtain the hardness characteristics that correspond to the time-dependent data using the correspondence stored in the storage device. In this manner, the hardness characteristics can be obtained from the similarity between the time-dependent data stored in advance and the actual detected time-dependent data without calculating an index, such as the load increase rate.

In the component mounting machine of the present invention, the storage device may store the correspondence for each reference value of a load applied to the board, and the control device may use load information detected by the load detector when the head is controlled such that the component holding tool comes into contact with the board at a predetermined low speed and a preset load is applied to the board, as the load information, select a reference value that matches or is replaceable with the preset load from among the reference values, and use, as the correspondence, the correspondence of the selected reference value. The relationship between the load increase rate and the hardness characteristics changes depending on the load applied to the board. Therefore, it is preferable to obtain the hardness characteristics with high precision by selecting a reference value that matches or is replaceable with a preset load from among the reference values and using the correspondence between the selected reference values.

In the component mounting machine of the present invention, the control device may set an approach speed at which the component holding tool approaches the board based on the hardness characteristics. In this manner, it is possible to set the approach speed that corresponds to the hardness characteristics. Otherwise, the control device may set the approach speed based on the hardness characteristics and the preset load. In this manner, it is possible to set the approach speed that corresponds to the hardness characteristics and the preset load. Here, when setting the approach speed, a speed close to the upper limit of the permissible range of the load may be set. In this manner, it is possible to shorten the time required for component mounting. In addition, the control device may set the approach speed for each component mounting point on the board. This is because the hardness characteristics may differ when the component mounting points are different even for the same board.

In the component mounting machine of the present invention, the control device may obtain the hardness characteristics using the load information detected by the load detector when the component holding tool comes into contact with the board at a predetermined low speed, and set the approach speed at which the component holding tool approaches the board to a low speed or a speed higher than the low speed based on the obtained hardness characteristics.

In the component mounting machine of the present invention, the head may have an impact softening mechanism for softening an impact when the component holding tool comes into contact with the board, and the control device may control the impact softening mechanism to cancel a reaction force generated when the component holding tool comes into contact with the board. In this manner, even when the approach speed of the component holding tool is high to a certain degree, it is possible to prevent the component held by the component holding tool from being broken by the impact when the component comes into contact with the board.

### Industrial applicability

The present invention can be applied to a component mounting machine, a component mounting system incorporating the component mounting machine, and the like.

### Reference Signs List

10 component mounting machine, 12 board conveyance unit, 14 support plate, 16 conveyor belt, 17 support pin, 18 mounting head, 19 support cylinder, 20 X-axis slider, 22 guide rail, 24 Y-axis slider, 26 guide rail, 30 nozzle holder, 30a rotation transmission gear, 30b flange, 30c guide groove, 30d upper annular protrusion, 30e lower annular protrusion, 31 nozzle rotation motor, 32 driving gear, 33 first arm, 33a first engaging section, 34 first linear motor, 35 guide member, 36 lock sleeve, 37 lock spring, 42 nozzle, 42a ventilation passage, 42b suction port, 42c flange, 42d spring receiving section, 42e step surface, 42f shaft section, 42g long hole, 43 pressure adjustment device, 44 nozzle sleeve, 44a pin, 46 nozzle spring, 50 second linear motor, 51 second arm, 52 second engaging section, 53 load cell, 64 mark camera, 66 part camera, 70 component supply unit, 72 reel, 74 feeder, 77 feeder controller, 78 controller, 78a CPU, 78b ROM, 78c HDD, 78d RAM, 78e input device, 78f display device, 80 management computer, 82 personal computer main body, 84 input device, 86 display device.

## Claims

1. A component mounting machine (10) comprising:
a component supply device (70) configured to supply a component;
a board holding device (12) configured to hold a board;
a head (18) configured to hold a component holding tool (42) to be capable of lifting and lowering the component holding tool (42);
a load detector (53) configured to detect a load applied to the component holding tool (42);
a head moving device (20, 24) configured to move the head (18) between the component supply device (70) and the board holding device (12); and
a control device (78) configured to obtain hardness characteristics when the component holding tool (42) comes into contact with the board or the component holding tool (42) that holds the component comes into indirect contact with the board via the component, based on load information detected by the load detector (53) when the head is controlled such that the component holding tool (42) comes into contact with the board,
wherein the load information is time-dependent data that represents a time-dependent change of the load;
the machine further comprises a storage device (78c) configured to store a correspondence between the time-dependent data and the hardness characteristics; and
the control device (78) is configured to obtain the hardness characteristics that correspond to the time-dependent data using the correspondence stored in the storage device (78c).

2. A component mounting machine (10) comprising:
a component supply device (70) configured to supply a component;
a board holding device (12) configured to hold a board;
a head (18) configured to hold a component holding tool (42) to be capable of lifting and lowering the component holding tool (42);
a load detector (53) configured to detect a load applied to the component holding tool (42);
a head moving device (20, 24) configured to move the head (18) between the component supply device (70) and the board holding device (12); and
a control device (78) configured to obtain hardness characteristics when the component holding tool (42) comes into contact with the board or the component holding tool (42) that holds the component comes into indirect contact with the board via the component, based on load information detected by the load detector (53) when the head is controlled such that the component holding tool (42) comes into contact with the board,
wherein the load information is time-dependent data that represents a time-dependent change of the load;
wherein the control device (78) is configured to calculate a load increase rate per time measured, when the load rises based on the load information, and obtain the hardness characteristics based on the load increase rate, and
the component mounting machine further comprising
a storage device (78c) configured to store a correspondence between the load increase rate and the hardness characteristics; and
wherein the control device (78) is configured to obtain the hardness characteristics that correspond to the load increase rate using the correspondence stored in the storage device (78c).

3. The component mounting machine according to claim 1 or 2,
wherein the storage device (78c) is configured to store the correspondence for each reference value of a load applied to the board; and
the control device (78) is configured to use load information detected by the load detector (53) when the head (18) is controlled such that the component holding tool (42) comes into contact with the board at a predetermined low speed and a preset load is applied to the board, as the load information, select a reference value that matches or is replaceable with the preset load from among the reference values, and use, as the correspondence, a correspondence of the selected reference value.

4. The component mounting machine according to any one of claims 1 to 3,
wherein the control device (78) is configured to set an approach speed at which the component holding tool (42) approaches the board based on the hardness characteristics.

5. The component mounting machine of claim 4,
wherein the control device (78) is configured to set the approach speed based on the hardness characteristics and the preset load.

6. The component mounting machine of claim 5,
wherein the control device is configured to set the approach speed to a speed close to an upper limit of a permissible range of the load when setting the approach speed.

7. The component mounting machine according to any one of claims 4 to 6,
wherein the control device (78) is configured to set the approach speed for each component mounting position on the board.

8. The component mounting machine according to any one of claims 1 to 7,
wherein the control device (78) is configured to obtain the hardness characteristics using the load information detected by the load detector (53) when the component holding tool (42) comes into contact with the board at a predetermined low speed and set the approach speed at which the component holding tool (42) approaches the board to a low speed or a speed higher than the low speed based on the obtained hardness characteristics.

9. The component mounting machine according to any one of claims 1 to 8,
wherein the head (18) has an impact softening mechanism (44, 46, 50, 51, 52) for softening an impact when the component holding tool (42) comes into contact with the board, and
the control device (78) is configured to control the impact softening mechanism so as to cancel a reaction force generated when the component holding tool (42) comes into contact with the board.

## Patentansprüche

1. Maschine (10) zum Montieren von Bauteilen, die umfasst:
eine Bauteil-Zuführeinrichtung (70), die zum Zuführen eines Bauteils ausgeführt ist;
eine Platten-Halteeinrichtung (12), die zum Halten einer Platte ausgeführt ist;
einen Kopf (18), der so ausgeführt ist, dass er ein Bauteil-Haltewerkzeug (42) so hält, dass er in der Lage ist, das Bauteil-Haltewerkzeug (42) anzuheben und abzusenken;
einen Last-Detektor (53), der so ausgeführt ist, dass er eine auf das Bauteil-Haltewerkzeug (42) ausgeübte Last erfasst;
eine Kopf-Bewegungseinrichtung (20, 24), die so ausgeführt ist, dass sie den Kopf (18) zwischen der Bauteil-Zuführeinrichtung (70) und der Platten-Halteeinrichtung (12) bewegt; sowie
eine Steuerungseinrichtung (78), die so ausgeführt ist, dass sie Härteeigenschaften auf Basis von durch den Last-Detektor (53) erfassten Last-Informationen ermittelt, wenn das Bauteil-Haltewerkzeug (42) mit der Platte in Kontakt kommt oder das Bauteil-Haltewerkzeug (42) das das Bauteil hält, über das Bauteil in indirekten Kontakt mit der Platte kommt, wenn der Kopf so gesteuert wird, dass das Bauteil-Haltewerkzeug (42) in Kontakt mit der Platte kommt,
wobei die Last-Informationen zeitabhängige Daten sind, die eine zeitabhängige Änderung der Last darstellen;
die Maschine des Weiteren eine Speichereinrichtung (78c) umfasst, die zum Speichern einer Entsprechung zwischen den zeitabhängigen Daten und den Härteeigenschaften ausgeführt ist; und
die Steuerungseinrichtung (78) so ausgeführt ist, dass sie die Härteeigenschaften, die den zeitabhängigen Daten entsprechen, unter Verwendung der in der Speichereinrichtung (78c) gespeicherten Entsprechung ermittelt.

2. Maschine (10) zum Montieren von Bauteilen, die umfasst:
eine Bauteil-Zuführeinrichtung (70), die zum Zuführen eines Bauteils ausgeführt ist;
eine Platten-Halteeinrichtung (12), die zum Halten einer Platte ausgeführt ist;
einen Kopf (18), der so ausgeführt ist, dass er ein Bauteil-Haltewerkzeug (42) so hält, dass er in der Lage ist, das Bauteil-Haltewerkzeug (42) anzuheben und abzusenken;
einen Last-Detektor (53), der so ausgeführt ist, dass er eine auf das Bauteil-Haltewerkzeug (42) ausgeübte Last erfasst;
eine Kopf-Bewegungseinrichtung (20, 24), die so ausgeführt ist, dass sie den Kopf (18) zwischen der Bauteil-Zuführeinrichtung (70) und der Platten-Halteeinrichtung (12) bewegt; sowie
eine Steuerungseinrichtung (78), die so ausgeführt ist, dass sie Härteeigenschaften auf Basis von durch den Last-Detektor (53) erfassten Last-Informationen ermittelt, wenn das Bauteil-Haltewerkzeug (42) mit der Platte in Kontakt kommt oder das Bauteil-Haltewerkzeug (42) das das Bauteil hält, über das Bauteil in indirekten Kontakt mit der Platine kommt, wenn der Kopf so gesteuert wird, dass das Bauteil-Haltewerkzeug (42) in Kontakt mit der Platte kommt,
wobei die Last-Informationen zeitabhängige Daten sind, die eine zeitabhängige Änderung der Last darstellen;
wobei die Steuerungseinrichtung (78) so ausgeführt ist, dass sie eine Last-Zunahmerate pro gemessener Zeit bei Zunahme der Last auf Basis der Last-Informationen berechnet, und die Härteeigenschaften auf Basis der Last-Zunahmerate ermittelt, und
die Maschine zum Montieren von Bauteilen des Weiteren umfasst:
eine Speichereinrichtung (78c), die so ausgeführt ist, dass sie eine Entsprechung zwischen der Last-Zunahmerate und den Härteeigenschaften speichert; und
die Steuerungseinrichtung (78) so ausgeführt ist, dass sie die Härteeigenschaften, die der Last-Zunahmerate entsprechen, unter Verwendung der in der Speichereinrichtung (78c) gespeicherten Entsprechung ermittelt.

3. Maschine zum Montieren von Bauteilen nach Anspruch 1 oder 2,
wobei die Speichereinrichtung (78c) so ausgeführt ist, dass sie die Entsprechung für jeden Bezugswert einer auf die Platte ausgeübten Last speichert; und
die Steuerungseinrichtung (78) so ausgeführt ist, dass sie die von dem Last-Detektor (53) erfassten Last-Informationen, wenn der Kopf (18) so gesteuert wird, dass das Bauteil-Haltewerkzeug (42) mit der Platte mit einer vorgegebenen niedrigen Geschwindigkeit in Kontakt kommt und eine voreingestellte Last auf die Platte ausgeübt wird, als die Last-Informationen verwendet, einen Bezugswert, der mit der voreingestellten Last übereinstimmt oder durch diese ersetzt werden kann, aus den Bezugswerten auswählt und als die Entsprechung eine Entsprechung des ausgewählten Bezugswertes verwendet.

4. Maschine zum Montieren von Bauteilen nach einem der Ansprüche 1 bis 3,
wobei die Steuerungseinrichtung (78) so ausgeführt ist, dass sie eine Annäherungsgeschwindigkeit, mit der sich das Bauteil-Haltewerkzeug (42) der Platte nähert, auf Basis der Härteeigenschaften einstellt.

5. Maschine zum Montieren von Bauteilen nach Anspruch 4,
wobei die Steuerungseinrichtung (78) so ausgeführt ist, dass sie die Annäherungsgeschwindigkeit auf Basis der Härteeigenschaften und der voreingestellten Last einstellt.

6. Maschine zum Montieren von Bauteilen nach Anspruch 5,
wobei die Steuerungseinrichtung so ausgeführt ist, dass sie beim Einstellen der Annäherungsgeschwindigkeit die Annäherungsgeschwindigkeit nahe an einer oberen Grenze eines zulässigen Bereiches der Last einstellt.

7. Maschine zum Montieren von Bauteilen nach einem der Ansprüche 4 bis 6,
wobei die Steuerungseinrichtung (78) so ausgeführt ist, dass sie die Annäherungsgeschwindigkeit für jede Bauteil-Montageposition auf der Platte einstellt.

8. Maschine zum Montieren von Bauteilen nach einem der Ansprüche 1 bis 7,
wobei die Steuerungseinrichtung (78) so ausgeführt ist, dass sie die Härteeigenschaften unter Verwendung der Last-Informationen ermittelt, die von dem Last-Detektor (53) erfasst werden, wenn das Bauteil-Haltewerkzeug (42) mit einer vorgegebenen niedrigen Geschwindigkeit in Kontakt mit der Platte kommt, und die Annäherungsgeschwindigkeit, mit der sich das Bauteil-Haltewerkzeug (42) der Platte nähert, auf Basis der ermittelten Härteeigenschaften auf eine niedrige Geschwindigkeit oder eine Geschwindigkeit einstellt, die höher ist als die niedrige Geschwindigkeit.

9. Maschine zum Montieren von Bauteilen nach einem der Ansprüche 1 bis 8,
wobei der Kopf (18) einen Aufschlag-Dämpfmechanismus (44, 46, 50, 51, 52) aufweist, mit dem ein Aufschlag gedämpft wird, wenn das Bauteil-Haltewerkzeug (42) in Kontakt mit der Platte kommt, und
die Steuerungseinrichtung (78) so ausgeführt ist, dass sie den Aufschlag-Dämpfmechanismus so steuert, dass eine Reaktionskraft aufgehoben wird, die erzeugt wird, wenn das Bauteil-Haltewerkzeug (42) in Kontakt mit der Platte kommt.

## Revendications

1. Machine de montage de composants (10) comprenant :
un dispositif d'approvisionnement en composants (70) configuré pour approvisionner un composant ;
un dispositif de maintien de carte (12) configuré pour maintenir une carte ;
une tête (18) configurée pour maintenir un outil de maintien de composant (42) afin d'être capable de lever et d'abaisser l'outil de maintien de composant (42) ;
un détecteur de charge (53) configuré pour détecter une charge appliquée à l'outil de maintien de composant (42) ;
un dispositif de déplacement de tête (20, 24) configuré pour déplacer la tête (18) entre le dispositif d'approvisionnement en composants (70) et le dispositif de maintien de carte (12) ; et
un dispositif de contrôle (78) configuré pour obtenir des caractéristiques de dureté quand l'outil de maintien de composant (42) entre en contact avec la carte ou quand l'outil de maintien de composant (42) qui maintient le composant entre en contact indirect avec la carte par l'intermédiaire du composant, sur la base d'information de charge détectée par le détecteur de charge (53) quand la tête est contrôlée de telle sorte que l'outil de maintien de composant (42) entre en contact avec la carte,
dans laquelle l'information de charge consiste en des données dépendant du temps qui représentent un changement de la charge dépendant du temps ;
la machine comprend en outre un dispositif de stockage (78c) configuré pour stocker une correspondance entre les données dépendant du temps et les caractéristiques de dureté ; et
le dispositif de contrôle (78) est configuré pour obtenir les caractéristiques de dureté qui correspondent aux données dépendant du temps en utilisant la correspondance stockée dans le dispositif de stockage (78c).

2. Machine de montage de composants (10) comprenant :
un dispositif d'approvisionnement en composants (70) configuré pour approvisionner un composant ;
un dispositif de maintien de carte (12) configuré pour maintenir une carte ;
une tête (18) configurée pour maintenir un outil de maintien de composant (42) afin d'être capable de lever et d'abaisser l'outil de maintien de composant (42) ;
un détecteur de charge (53) configuré pour détecter une charge appliquée à l'outil de maintien de composant (42) ;
un dispositif de déplacement de tête (20, 24) configuré pour déplacer la tête (18) entre le dispositif d'approvisionnement en composants (70) et le dispositif de maintien de carte (12) ; et
un dispositif de contrôle (78) configuré pour obtenir des caractéristiques de dureté quand l'outil de maintien de composant (42) entre en contact avec la carte ou quand l'outil de maintien de composant (42) qui maintient le composant entre en contact indirect avec la carte par l'intermédiaire du composant, sur la base d'information de charge détectée par le détecteur de charge (53) quand la tête est contrôlée de telle sorte que l'outil de maintien de composant (42) entre en contact avec la carte,
dans laquelle l'information de charge consiste en des données dépendant du temps qui représentent un changement de la charge dépendant du temps ;
dans laquelle le dispositif de contrôle (78) est configuré pour calculer un taux temporel d'augmentation de charge mesuré, quand la charge augmente sur la base de l'information de charge, et pour obtenir les caractéristiques de dureté sur la base du taux d'augmentation de charge, et
la machine de montage de composants comprenant en outre
un dispositif de stockage (78c) configuré pour stocker une correspondance entre le taux d'augmentation de charge et les caractéristiques de dureté ; et
dans laquelle le dispositif de contrôle (78) est configuré pour obtenir les caractéristiques de dureté qui correspondent au taux d'augmentation de charge en utilisant la correspondance stockée dans le dispositif de stockage (78c) .

3. Machine de montage de composants selon la revendication 1 ou 2,
dans laquelle le dispositif de stockage (78c) est configuré pour stocker la correspondance pour chaque valeur de référence d'une charge appliquée à la carte ; et
le dispositif de contrôle (78) est configuré pour utiliser comme information de charge de l'information de charge détectée par le détecteur de charge (53) quand la tête (18) est contrôlée de telle sorte que l'outil de maintien de composant (42) entre en contact avec la carte à une vitesse faible prédéterminée et une charge prédéfinie est appliquée à la carte, pour sélectionner une valeur de référence qui correspond à ou est remplaçable par la charge prédéfinie parmi les valeurs de référence, et pour utiliser, comme correspondance, une correspondance de la valeur de référence sélectionnée.

4. Machine de montage de composants selon l'une quelconque des revendications 1 à 3,
dans laquelle le dispositif de contrôle (78) est configuré pour régler une vitesse d'approche à laquelle l'outil de maintien de composant (42) s'approche de la carte sur la base des caractéristiques de dureté.

5. Machine de montage de composants selon la revendication 4,
dans laquelle le dispositif de contrôle (78) est configuré pour régler la vitesse d'approche sur la base des caractéristiques de dureté et de la charge prédéfinie.

6. Machine de montage de composants selon la revendication 5,
dans laquelle le dispositif de contrôle est configuré pour régler la vitesse d'approche à une vitesse proche de la limite supérieure d'une plage admissible de la charge lors du réglage de la vitesse d'approche.

7. Machine de montage de composants selon l'une quelconque des revendications 4 à 6,
dans laquelle le dispositif de contrôle (78) est configuré pour régler la vitesse d'approche pour chaque position de montage de composant sur la carte.

8. Machine de montage de composants selon l'une quelconque des revendications 1 à 7,
dans laquelle le dispositif de contrôle (78) est configuré pour obtenir les caractéristiques de dureté en utilisant l'information de charge détectée par le détecteur de charge (53) lorsque l'outil de maintien de composant (42) entre en contact avec la carte à une vitesse faible prédéterminée et pour régler la vitesse d'approche à laquelle l'outil de maintien de composant (42) s'approche de la carte à une vitesse faible ou à une vitesse supérieure à la vitesse faible sur la base des caractéristiques de dureté obtenues.

9. Machine de montage de composants selon l'une quelconque des revendications 1 à 8,
dans laquelle la tête (18) comporte un mécanisme d'amortissement d'impact (44, 46, 50, 51, 52) pour atténuer un impact quand l'outil de maintien de composant (42) vient en contact avec la carte, et
le dispositif de contrôle (78) est configuré pour contrôler le mécanisme d'amortissement d'impact de manière à annuler la force de réaction générée quand l'outil de maintien de composant (42) vient en contact avec la carte.
